# EUROPEAN PATENT SPECIFICATION

(11) **EP 3 893 387 B1**
(45) Date of publication and mention of the grant of the patent: **25.09.2024**
(21) Application number: 21152187.7
(22) Date of filing: 18.01.2021
(51) Int. Cl.: H02P 29/60, B64D 41/00, H02N 2/18, B64D 33/00, B64D 27/00

(54) **SENSOR SYSTEM**
SENSORSYSTEM
SYSTÈME DE CAPTEUR

(30) Priority: 09.04.2020 GB 202005316
(43) Date of publication of application: 13.10.2021
(73) Proprietor: Hamilton Sundstrand Corporation, Charlotte, NC 28217-4578 (US)
(72) Inventor: POPEK, Grzegorz, Solihull, West Midlands B90 4SS (GB); BENN, Andrew J., Solihull, West Midlands B90 4SS (GB)
(74) Representative: Dehns

(56) References cited:
- US-A1- 2007 114 422
- US-A1- 2011 060 535
- US-A1- 2019 341 954
- BEEBY S P ET AL: "REVIEW ARTICLE; Energy harvesting vibration sources for microsystems applications", MEASUREMENT SCIENCE AND TECHNOLOGY, IOP, BRISTOL, GB, vol. 17, no. 12, 1 December 2006 (2006-12-01), pages R175 - R195, XP020103319, ISSN: 0957-0233, DOI: 10.1088/0957-0233/17/12/R01

## Description

### Technical Field

This disclosure relates to a sensor system for use in aerospace applications, particularly a sensor system for monitoring a motor in an aerospace application, where a sensor is powered by harvested energy.

### Background Art

In aerospace applications, there may be one or more motors that are supplied to drive actuators within the aircraft, where the commutation of these motors is generally controlled by a control system. These motors are generally supplied with electrical power by a power converter that supplies electrical power. As will be understood by those skilled in the art, the power converter converts power from a source (such as a battery) to a form suitable for supply to the motor and other systems.

In order to control commutation of the motor, the position of the rotor must be 'known' by the control system, where the position information has traditionally been supplied by a sensors, such as Hall effect sensors.

Senseless (or 'sensorless') control systems exist in which voltage and/or current information from the motor can be used to determine information relating to the position of the rotor. Recent advancements in senseless control techniques allows for driving the salient permanent magnet (PM) motors over their full speed range without significant loss of torque. Such techniques provide for reduction in the cost of the electric machine, and may remove the harness required to carry either Hall effect or resolver signals, which are prone to noise interferences due to close proximity of the machine feeder cables.

Unfortunately, in many applications such as aerospace actuator applications, it is typically necessary to monitor the temperature of motor windings, e.g. using simple resistive temperature detectors (RTD). This monitoring requires a low voltage harness between the power converter and the motor in order to provide power to the sensors and to return data from the sensor that conveys the temperature signal from the sensor. This 'low voltage harness' between the motor and the converter can, in some applications, be up to 30m long. Those skilled in the art will appreciate that such a harness has a considerable physical volume and significant mass associated with it, which is highly undesirable for aerospace applications.

US 2011/060535 A1 discloses a device that can that can be attached to a structure or live subject and that can harvest energy from its environment to power sensing, storing and transmitting data about the structure or live subject.

US 2019/341954 A1 discloses an antenna, a microcontroller, and a power source. The power source is configured to generate power in response to ambient energy received at a first frequency during a cycle of energy harvesting using the antenna. The power is transferred to a power storage cell such that when the power storage cell has an amount of power the microcontroller of the device processes at least a part of a processing task to be sent to an end node, and a result of processing of said at least said part of the processing task is stored. During one or more additional cycles of energy harvesting, using generated power to process one or more additional parts of the processing task to assemble a payload or process a wireless transmission of the payload. The wireless transmission of the payload is sent over a second frequency to the end node.

### Summary of the Disclosure

In accordance with a first aspect, the present disclosure provides a sensor system for monitoring a motor in an aircraft, in accordance with claim 1.

The first aspect of the disclosure also extends to a method of monitoring a motor in an aircraft, in accordance with claim 11.

Thus it will be appreciated that examples of the present disclosure overcome the issues outlined above by powering a sensor using mechanical energy harvested from motion of the aircraft itself. As the wireless sensor can be powered locally by the energy harvesting unit, examples of the present disclosure may advantageously avoid the need for a wiring harness to carry power (e.g. from a main power converter of the aircraft to the sensor), which may be located remotely (e.g. of such a main power converter). Moreover, as the sensor is wireless, there may also be no need to provide a signal harness. Thus the present disclosure advantageously allows the benefits of senseless control of the aircraft's motor to be fully realised.

Those skilled in the art will appreciate that the term 'aircraft' as used herein extends to any vehicle that can fly, including but not limited to airplanes, helicopters, airships, blimps, and powered gliders.

Avoiding any wiring harness to the sensor that monitors the motor may also be beneficial due to a reduction in the weight and volume associated with the wiring harness that would have otherwise been required without the present disclosure. As outlined above, conventional wiring harnesses, known in the art *per se*, may be around 30 m long, and be undesirably 'bulky'.

The present disclosure may be particularly advantageous for electric aircraft, i.e. aircraft that have fully electric (e.g. battery-powered) propulsion systems. The power source (e.g. a battery), may be located on the aircraft which is beneficial for weight-distribution purposes, while the wireless sensor can be provided proximate to the motor elsewhere on the aircraft without needing to run a wiring harness from that central power source location to the motor location.

The aircraft may comprise a power converter that drives the motor, where there is no electrical connection between the power converter that drives the motor and the wireless sensor. Such a power converter may source power from a suitable power source, e.g. a battery as outlined above or a 'conventional' aircraft engine such as a piston engine or gas turbine.

Additionally, avoiding the use of a wiring harness may advantageously help to avoid crosstalk noise between the sensor's interface signals and feeder cables.

The energy harvesting unit may be mechanically coupled to any part of the aircraft that exhibits motion, e.g. that vibrates. The energy harvesting unit is mechanically coupled to a component of the aircraft, and may be one of the following: a wing, a blade, a landing gear, or a flight control surface of the aircraft.

In some examples, the mass-spring arrangement has a resonant frequency substantially matched to a vibration frequency of the aircraft. Thus the method may, in some examples, further comprise determining the vibration frequency of the aircraft and substantially matching a vibration frequency of the mass-spring unit to the vibration frequency of the aircraft. It will be appreciated by those skilled in the art that the term 'vibration frequency of the aircraft' should be understood to mean a frequency of mechanical vibration that is known to exist within the aircraft.

It will be appreciated that there are a number of parameters of the motor that may be monitored with an appropriate sensor in accordance with examples of the present disclosure. However, in some examples, the wireless sensor comprises a temperature sensor, and optionally may comprise an RTD. Thus, in accordance with such examples, the parameter of the motor may comprise a temperature of the motor.

In some examples, multiple parameters of the motor may be monitored. A specific wireless sensor may itself monitor multiple different parameters, and/or the sensor system may comprise a plurality of wireless sensors, each arranged to monitor one or more parameters. Similarly, the aircraft may comprise a plurality of motors, wherein one or more wireless sensors may be provided to monitor some or all of these motors. In examples in which multiple parameters are monitored by one or more sensors, these may include parameters that are not necessarily parameters of the motor, for example a temperature elsewhere on the aircraft may be monitored, however in some examples multiple parameters of the motor may be monitored.

There are a number of mechanisms to convert the motion of the mass-spring unit to electrical energy, however in some examples, the energy harvesting unit may use magnetic, piezoelectric, and/or electrostatic methods. For ease of understanding only, the mass-spring arrangement may be seen as analogous to a 'tuning fork', where the motion of the aircraft, for example due to vibration from the motor or due to other causes of such vibration, gives rise to a vibration of the tuning fork (i.e. of the mass-spring unit).

With magnetic methods, the motion of the mass-spring unit causes a magnet to move relative to a coil. Thus the mass-spring unit may comprise a magnet that moves relative to a coil. Additionally or alternatively, the mass-spring unit may comprise a coil that moves relative to a magnet. As the magnet moves relative to the coil in response to the motion of the mass-spring unit, this induces an electrical current in the coil, thus providing the conversion of the mechanical energy of the aircraft to electrical energy for supply to the wireless sensor. Thus, in some examples, the mass-spring unit comprises a magnet and a coil, wherein motion of the mass spring unit moves the magnet relative to the coil, thereby generating the electrical energy.

The piezoelectric method, which may be used with some examples of the present disclosure, involves mechanically coupling the mass-spring unit to a piezoelectric element. Those skilled in the art will appreciate that a piezoelectric element is a device (typically a crystalline solid structure) that generates an electric charge in response to mechanical stress (e.g. when it is 'squeezed' or 'pressed'). Motion of the mass-spring unit causes a mechanical stress of the piezoelectric element, thereby generating an electrical charge that can be used to power the wireless sensor. Thus, in some examples, the mass-spring unit comprises a piezoelectric element, wherein motion of the mass spring unit applies a mechanical stress to the piezoelectric element, thereby generating the electrical energy.

The electrostatic method, used in accordance with some examples of the disclosure, makes use of a difference in electrostatic charge on the mass-spring unit compared to the electrostatic charge on a 'plate' proximate to the mass-spring unit. The mass-spring unit moves relative to a plate, where the varying distance or plate overlap causes a change in voltage, i.e. the arrangement behaves like a capacitor. Thus, in some examples, the mass-spring unit comprises first and second capacitive plates, wherein motion of the mass spring unit moves the capacitive plates relative to one another, thereby generating the electrical energy.

A combination of these different types of energy harvesting techniques may be used.

The wireless sensor transmits data to the external wireless receiver via a wireless communication interface. It will be appreciated that there are a number of wireless communication interfaces, known in the art *per se*, that could be used, including but not limited to Bluetooth^{®}, Wi-Fi^{™}, ZigBee^{®}, or a proprietary wireless communication interface. The wireless communication interface can be selected depending on, for example, the wireless communication characteristics that are required (e.g. frequency, modulation scheme, range, power, noise performance, security, etc.).

It will be appreciated that the optional features described above in relation to examples of the first aspect of the disclosure apply equally as optional features of the second aspect of the disclosure.

### Brief Description of the Drawings

Certain examples of the present disclosure will now be described with reference to the accompanying drawings, in which:
Fig. 1 is a block diagram of a prior art motor drive system;
Fig. 2 is a block diagram of a motor drive system in accordance with an example of the present disclosure; and
Fig. 3 is a block diagram of the wireless sensor unit used in the motor drive system of Fig. 2.

### Detailed Description

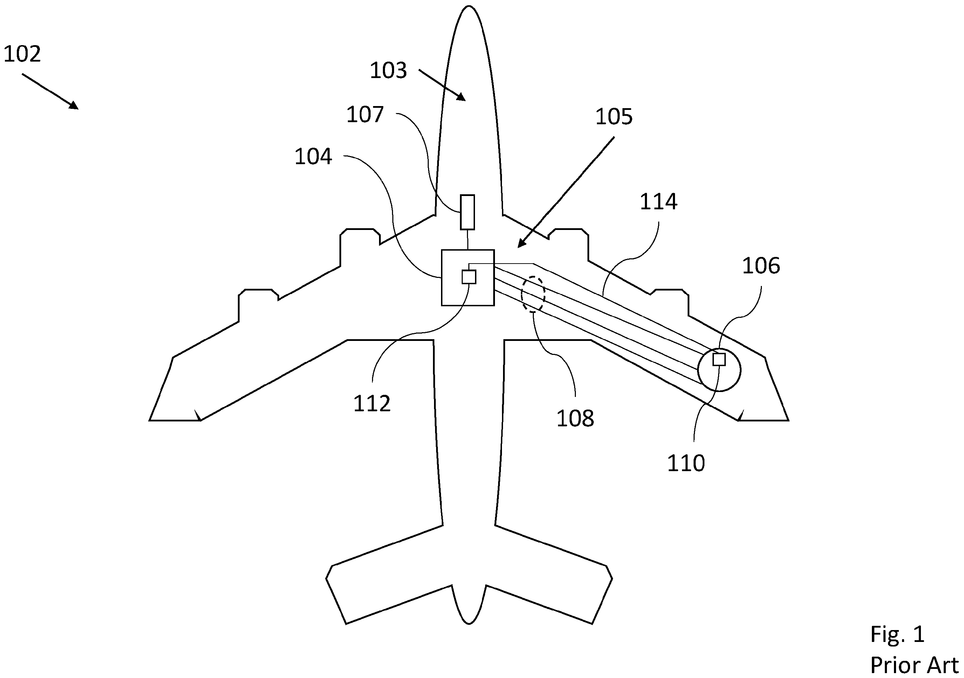

Fig. 1 is a block diagram of a prior art motor drive system on an aircraft 102. The aircraft 102, which in this example is an airplane, has a fuselage portion 103 and a wing portion 105. It will be appreciated that there are, of course, many other components to an aircraft, however these simplified 'portions' 103, 105 are illustrated broadly for ease of reference.

In this particular example, the aircraft 102 is an electric aircraft, and is provided with a power converter 104 located at the centre of the fuselage portion 103. This power converter 104 draws power from a battery 107 and converts the battery voltage to voltages suitable for supply to other systems of the aircraft 102, including a motor 106. In practice, there may be many motors on the aircraft 102, however for ease of illustration, a single motor 106 is shown on the wing portion 105 of the aircraft 102. The motor 106 is connected to the power converter via wiring harness 108.

A temperature sensor 110 is provided on the motor 106 and is arranged to monitor the temperature of the motor 106 during use. This sensor 110 is connected to the power converter 104 via a wiring harness 114, where this wiring harness is used to deliver electrical power from the power converter 104 to the temperature sensor 110, and to return temperature data to a receiver 112 within the power converter 104. The temperature data from the temperature sensor 110 may be used by the power converter 104 when determining the voltage and/or current supplied to the motor 106.

Thus while the motor 106 may be driven by the power converter 104 without a feedback loop monitoring the motion of the motor 106, i.e. in accordance with 'senseless control' principles, a wiring harness 114 is nonetheless required in order to supply power to, and receive data from, the temperature sensor 110, preventing the prior art system from fully realising the benefits of senseless control.

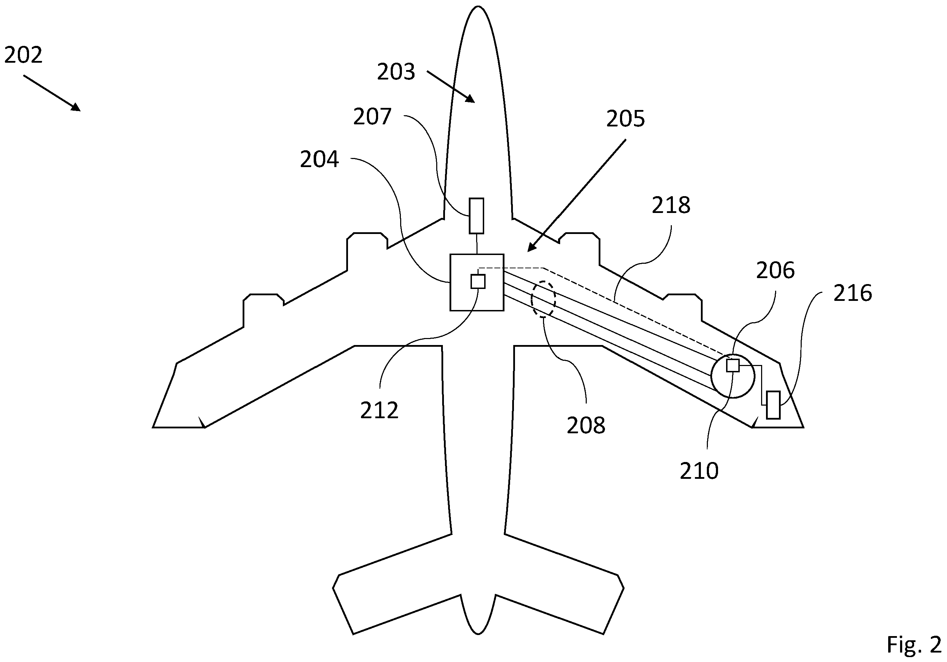

Fig. 2 is a block diagram of a motor drive system on an aircraft 202 in accordance with an example of the present disclosure. Many of the components used in the aircraft 202 of Fig. 2 correspond to those in Fig. 1, where reference numerals starting with a '2' in Fig. 2 correspond to those with reference numerals starting with a '1' in Fig. 1.

Unlike in the aircraft 102 of Fig. 1, the aircraft 202 of Fig. 2 is provided with an energy harvesting unit 216, which is mechanically coupled to the wing portion 205 of the aircraft 202. This energy harvesting unit 216 includes a mass-spring arrangement, where the mass is free to move on the spring in response to motion of the wing portion 205. The mass-spring arrangement has a resonant frequency that corresponds to a natural (i.e. resonant) frequency of the wing portion 205.

This energy harvesting unit 216 converts mechanical energy from the motion (e.g. vibration) of the wing portion 205 to electrical energy, and supplies this harvested electrical energy to the sensor unit 210.

A further change from the aircraft 102 of Fig. 1 is that the sensor unit 210 in the aircraft 202 of Fig. 2 is wireless, i.e. it conveys the temperature data to the receiver 214 over a wireless communication interface 218. The wireless communication interface 218 can be selected depending on, for example, the wireless communication characteristics that are required (e.g. frequency, modulation scheme, range, power, noise performance, security, etc.). It will be appreciated that there are a number of wireless communication interfaces, known in the art *per se*, that could be used, including but not limited to Bluetooth^{®}, Wi-Fi^{™}, ZigBee^{®}, or a proprietary wireless communication interface. The present disclosure is not limited to any one particular interface.

This combination of the use of a wireless sensor unit 210 together with an energy harvesting unit 216, located close to the wireless sensor unit 210, removes the need for the wiring harness 114 used in the prior art aircraft 102. This cuts down on the amount of weight associated with the wiring of the aircraft 202, and results in more physical volume being free. The aircraft 202 of Fig. 2 may also suffer less crosstalk than the aircraft 102 of Fig. 1.

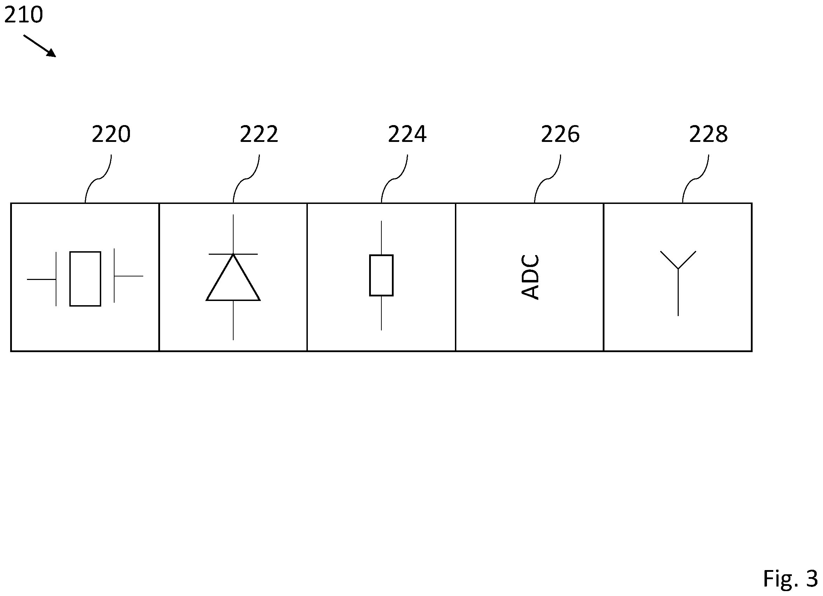

Fig. 3 is a block diagram of the wireless sensor unit 210 used in the motor drive system of Fig. 2. The wireless sensor unit 210 comprises a mass-spring unit 220, where the mass-spring unit 210 includes a magnetic or piezoelectric transducer which converts mechanical energy from the vibrations of the aircraft 202 (in this case the wing portion 205) to electrical energy (i.e. a voltage).

This electrical energy is then rectified and conditioned by electronic circuitry 222. The rectified energy then is being used to power up the temperature sensor 224, the measurements then being digitised by an analogue-to-digital converter (ADC) 226. The digital data corresponding to the measured temperature of the motor 206 is then transmitted via a wireless transmitter 228 to the wireless receiver 212 in the main power converter 204.

Thus examples of the present disclosure provide an improved motor drive system for aircraft in which a wireless sensor is powered using mechanical energy harvested from motion of the aircraft itself, thereby avoid the need for any wiring or signal harnesses to carry power and data between a remote part of the aircraft and the main power converter. Thus the present disclosure advantageously allows the benefits of senseless control of the aircraft's motor to be fully realised.

## Claims

1. A sensor system for monitoring a motor (206) in an aircraft (202), the sensor system comprising:
a wireless sensor (210) arranged to measure a parameter of the motor, said wireless sensor being further arranged to transmit said parameter to an external wireless receiver (212);
an energy harvesting unit (216) comprising a mass-spring unit (220) arranged to be mechanically coupled to the aircraft;
wherein the energy harvesting unit is arranged to convert mechanical energy arising from motion of the mass-spring unit to electrical energy using magnetic, piezoelectric, and/or electrostatic methods, and to supply said electrical energy to the wireless sensor;
**characterised in that**
the energy harvesting unit is arranged to be mechanically coupled to a component of the aircraft, wherein the component comprises one or more of the following: a wing; a blade; a landing gear; and/or a flight control surface of the aircraft.

2. The sensor system as claimed in claim 1, wherein the mass-spring arrangement (220) has a resonant frequency substantially matched to a vibration frequency of the aircraft (202).

3. The sensor system as claimed in claim 1 or 2, wherein the wireless sensor (210) comprises a temperature sensor (224), and optionally may comprise a resistive temperature detector, wherein the parameter of the motor (206) comprises a temperature of the motor.

4. The sensor system as claimed in claim 1, 2 or 3, arranged to monitor multiple parameters, optionally wherein the sensor system is arranged to monitor multiple parameters of the motor (206).

5. The sensor system as claimed in claim 4, wherein the wireless sensor (210) monitors multiple different parameters of the motor (206).

6. The sensor system as claimed in claim 4 or 5, comprising a plurality of wireless sensors (210), each wireless sensor being arranged to monitor one or more parameters of the motor (206).

7. The sensor system as claimed in any preceding claim, wherein the mass-spring unit (220) comprises a magnet and a coil, wherein motion of the mass spring unit moves the magnet relative to the coil, thereby generating the electrical energy.

8. The sensor system as claimed in any of claims 1-6, wherein the mass-spring unit (220) comprises a piezoelectric element, wherein motion of the mass spring unit applies a mechanical stress to the piezoelectric element, thereby generating the electrical energy.

9. The sensor system as claimed in any of claims 1-6, wherein the mass-spring unit (220) comprises first and second capacitive plates, wherein motion of the mass spring unit moves the capacitive plates relative to one another, thereby generating the electrical energy.

10. An aircraft (202) comprising a motor (206) and a sensor system as claimed in any preceding claim.

11. A method of monitoring a motor (206) in an aircraft (202), said method comprising:
converting mechanical energy arising from motion of a mass-spring unit (220) mechanically coupled to the aircraft to electrical energy using magnetic, piezoelectric, and/or electrostatic methods;
supplying the electrical energy to a wireless sensor (210);
measuring a parameter of the motor using the wireless sensor; and
transmitting said parameter to an external wireless receiver (212);
**characterised in that**
an energy harvesting unit (216) is arranged to be mechanically coupled to a component of the aircraft, wherein the component comprises one or more of the following: a wing; a blade; a landing gear; and/or a flight control surface of the aircraft.

12. The method as claimed in claim 11, comprising:
determining a vibration frequency of the aircraft (202) and substantially matching a resonant frequency of the mass-spring unit (220) to the vibration frequency of the aircraft.

## Patentansprüche

1. Sensorsystem zum Überwachen eines Motors (206) in einem Flugzeug (202), wobei das Sensorsystem Folgendes umfasst:
einen drahtlosen Sensor (210), der angeordnet ist, um einen Parameter des Motors zu messen, wobei der drahtlose Sensor ferner angeordnet ist, um den Parameter an einen externen drahtlosen Empfänger (212) zu übertragen;
eine Energiegewinnungseinheit (216), die eine Masse-Feder-Einheit (220) umfasst, die angeordnet ist, um mechanisch mit dem Flugzeug gekoppelt zu werden;
wobei die Energiegewinnungseinheit angeordnet ist, um mechanische Energie, die aus Bewegung der Masse-Feder-Einheit entsteht, unter Verwendung magnetischer, piezoelektrischer und/oder elektrostatischer Verfahren in elektrische Energie umzuwandeln und die elektrische Energie dem drahtlosen Sensor zuzuführen;
**dadurch gekennzeichnet, dass**
die Energiegewinnungseinheit angeordnet ist, um mechanisch mit einer Komponente des Flugzeugs gekoppelt zu werden, wobei die Komponente eines oder mehrere von Folgenden umfasst: einen Flügel; ein Rotorblatt; ein Fahrwerk und/oder eine Flugsteuerungsfläche des Flugzeugs.

2. Sensorsystem nach Anspruch 1, wobei die Masse-FederAnordnung (220) eine Resonanzfrequenz aufweist, die im Wesentlichen an eine Schwingungsfrequenz des Flugzeugs (202) angepasst ist.

3. Sensorsystem nach Anspruch 1 oder 2, wobei der drahtlose Sensor (210) einen Temperatursensor (224) umfasst und optional einen Widerstandstemperaturdetektor umfassen kann, wobei der Parameter des Motors (206) eine Temperatur des Motors umfasst.

4. Sensorsystem nach Anspruch 1, 2 oder 3, angeordnet, um mehrere Parameter zu überwachen, wobei optional das Sensorsystem angeordnet ist, um mehrere Parameter des Motors (206) zu überwachen.

5. Sensorsystem nach Anspruch 4, wobei der drahtlose Sensor (210) mehrere verschiedene Parameter des Motors (206) überwacht.

6. Sensorsystem nach Anspruch 4 oder 5, umfassend eine Vielzahl von drahtlosen Sensoren (210), wobei jeder drahtlose Sensor angeordnet ist, um einen oder mehrere Parameter des Motors (206) zu überwachen.

7. Sensorsystem nach einem der vorhergehenden Ansprüche, wobei die Masse-Feder-Einheit (220) einen Magneten und eine Spule umfasst, wobei Bewegung der Masse-Feder-Einheit den Magneten relativ zu der Spule bewegt und dadurch die elektrische Energie erzeugt.

8. Sensorsystem nach einem der Ansprüche 1-6, wobei die Masse-Feder-Einheit (220) ein piezoelektrisches Element umfasst, wobei Bewegung der Masse-Feder-Einheit eine mechanische Spannung an das piezoelektrische Element anlegt und dadurch die elektrische Energie erzeugt.

9. Sensorsystem nach einem der Ansprüche 1-6, wobei die Masse-Feder-Einheit (220) eine erste und eine zweite kapazitive Platte umfasst, wobei Bewegung der Masse-Feder-Einheit die kapazitiven Platten relativ zueinander bewegt und dadurch die elektrische Energie erzeugt.

10. Flugzeug (202), umfassend einen Motor (206) und ein Sensorsystem nach einem der vorhergehenden Ansprüche.

11. Verfahren zum Überwachen eines Motors (206) in einem Flugzeug (202), wobei das Verfahren Folgendes umfasst:
Umwandeln mechanischer Energie, die aus Bewegung einer mechanisch mit dem Flugzeug gekoppelten Masse-Feder-Einheit (220) entsteht, unter Verwendung magnetischer, piezoelektrischer und/oder elektrostatischer Verfahren in elektrische Energie;
Zuführen der elektrischen Energie zu dem drahtlosen Sensor (210) ;
Messen eines Parameters des Motors unter Verwendung des drahtlosen Sensors; und
Übertragen des Parameters an einen externen drahtlosen Empfänger (212);
**dadurch gekennzeichnet, dass**
eine Energiegewinnungseinheit (216) angeordnet ist, um mechanisch mit einer Komponente des Flugzeugs gekoppelt zu werden, wobei die Komponente eines oder mehrere von Folgenden umfasst: einen Flügel; ein Rotorblatt; ein Fahrwerk und/oder eine Flugsteuerungsfläche des Flugzeugs.

12. Verfahren nach Anspruch 11, umfassend:
Bestimmen einer Schwingungsfrequenz des Flugzeugs (202) und im Wesentlichen Anpassen einer Resonanzfrequenz der Masse-Feder-Einheit (220) an die Schwingungsfrequenz des Flugzeugs.

## Revendications

1. Système de capteur pour surveiller un moteur (206) dans un aéronef (202), le système de capteur comprenant :
un capteur sans fil (210) agencé pour mesurer un paramètre du moteur, ledit capteur sans fil étant également agencé pour transmettre ledit paramètre à un récepteur sans fil externe (212) ;
une unité de récupération d'énergie (216) comprenant une unité masse-ressort (220) agencée pour être couplée mécaniquement à l'aéronef ;
dans lequel l'unité de récupération d'énergie étant conçue pour convertir l'énergie mécanique résultant du mouvement de l'unité masse-ressort en énergie électrique à l'aide de procédés magnétiques, piézoélectriques et/ou électrostatiques, et pour fournir ladite énergie électrique au capteur sans fil ;
**caractérisé en ce que**
l'unité de récupération d'énergie est conçue pour être couplée mécaniquement à un composant de l'aéronef, dans lequel le composant comprend un ou plusieurs de : une aile ; une aube ; un train d'atterrissage ; et/ou une gouverne de vol de l'aéronef.

2. Système de capteur selon la revendication 1, dans lequel l'agencement masse-ressort (220) a une fréquence de résonance sensiblement adaptée à une fréquence de vibration de l'aéronef (202) .

3. Système de capteur selon la revendication 1 ou 2, dans lequel le capteur sans fil (210) comprend un capteur de température (224), et peut éventuellement comprendre un détecteur de température résistif, dans lequel le paramètre du moteur (206) comprend une température du moteur.

4. Système de capteur selon la revendication 1, 2 ou 3, agencé pour surveiller de multiples paramètres, éventuellement dans lequel le système de capteur est agencé pour surveiller de multiples paramètres du moteur (206).

5. Système de capteur selon la revendication 4, dans lequel le capteur sans fil (210) surveille de multiples paramètres différents du moteur (206).

6. Système de capteur selon la revendication 4 ou 5, comprenant une pluralité de capteurs sans fil (210), chaque capteur sans fil étant agencé pour surveiller un ou plusieurs paramètres du moteur (206).

7. Système de capteur selon une quelconque revendication précédente, dans lequel l'unité masse-ressort (220) comprend un aimant et une bobine, dans lequel le mouvement de l'unité masse-ressort déplace l'aimant par rapport à la bobine, générant ainsi l'énergie électrique.

8. Système de capteur selon l'une quelconque des revendications 1 à 6, dans lequel l'unité masse-ressort (220) comprend un élément piézoélectrique, dans lequel le mouvement de l'unité masse-ressort applique une contrainte mécanique à l'élément piézoélectrique, générant ainsi l'énergie électrique.

9. Système de capteur selon l'une quelconque des revendications 1 à 6, dans lequel l'unité masse-ressort (220) comprend des première et seconde plaques capacitives, dans lequel le mouvement de l'unité masse-ressort déplace les plaques capacitives l'une par rapport à l'autre, générant ainsi l'énergie électrique.

10. Aéronef (202) comprenant un moteur (206) et un système de capteur selon une quelconque revendication précédente.

11. Procédé de surveillance d'un moteur (206) dans un aéronef (202), ledit procédé comprenant :
la conversion de l'énergie mécanique résultant du mouvement d'une unité masse-ressort (220) couplée mécaniquement à l'aéronef en énergie électrique à l'aide de procédés magnétiques, piézoélectriques et/ou électrostatiques ;
la fourniture de l'énergie électrique à un capteur sans fil (210) ;
la mesure d'un paramètre du moteur à l'aide du capteur sans fil ; et
la transmission dudit paramètre à un récepteur sans fil externe (212) ;
**caractérisé en ce que**
l'unité de récupération d'énergie (216) est conçue pour être couplée mécaniquement à un composant de l'aéronef, dans lequel le composant comprend un ou plusieurs de : une aile ; une aube ; un train d'atterrissage ; et/ou une gouverne de vol de l'aéronef.

12. Procédé selon la revendication 11, comprenant :
la détermination d'une fréquence de vibration de l'aéronef (202) et le fait de faire correspondre sensiblement une fréquence de résonance de l'unité masse-ressort (220) à la fréquence de vibration de l'aéronef.
